# DEMANDE DE BREVET EUROPEEN

(11) **EP 2 262 115 A1**
(43) Date de publication de la demande: **15.12.2010**
(21) Numéro de dépôt: 10165604.9
(22) Date de dépôt: 11.06.2010
(51) Int. Cl.: H03M 13/29, H03M 13/27

(54) **Procédé et dispositif de segmentation de blocs de transport dans un reseau de radiocommunication**

(30) Priorité: 12.06.2009 FR 0902865
(71) Demandeur: Alcatel Lucent, 75007 Paris (FR)
(72) Inventeur: Krief, Patrick-Albert, 78141, VELIZY (FR); Ben Rached, Nidham, 78141, VELIZY (FR)
(74) Mandataire: Ameline, Jean-Paul B.C.

(57) **Abrégé**

Un procédé est dédié à la segmentation de blocs de transport de données en segments dans un réseau de radiocommunication. Ce procédé comprend une étape i) consistant à segmenter un bloc de transport de données à transmettre, de taille donnée B, en un nombre entier C de segments de tailles sensiblement identiques, tel que la somme des tailles de ces segments soit supérieure ou égale à la somme B' de la taille donnée B et du produit du nombre entier C par un nombre NC de bits de correction d'erreurs, et une étape ii) consistant à répartir de façon sensiblement équitable des données de bourrage dans les segments.

## Description

L'invention se rapporte aux méthodes de segmentation de blocs de transport de données utilisées dans la chaine de transmission de certains réseaux de radiocommunication.

Une telle méthode de segmentation de blocs de transport de données est notamment prévue dans les réseaux de radiocommunication de type LTE (« Long Term Evolution »), et plus précisément dans la partie de la chaîne de transmission qui est utilisée dans de tels réseaux LTE pour coder les canaux physiques de données partagés (appelés « DL-SCH » dans le sens descendant (ou « downlink » - c'est-à-dire du réseau vers les terminaux de communication), et « UL-SCH » dans le sens montant (ou « uplink » - c'est-à-dire des terminaux de communication vers le réseau)), en particulier en présence de hauts débits (typiquement lorsque la taille des blocs de transport (ou TBS (pour « Transport Block Size »)) est supérieure à environ 6000 bits).

La chaîne de transmission définie pour les réseaux LTE comprend une couche protocolaire RLC/MAC (pour « Radio Link Control / Medium Access Control ») au niveau de laquelle opère un ordonnanceur (ou « scheduler ») MAC (appartenant à la couche de liaison du modèle OSI) chargé d'allouer des ressources de transmission radio et de choisir un schéma de modulation/codage correspondant (ou MCS (pour « Modulation Coding Scheme »)) pour chaque terminal de communication. L'ordonnanceur (ou scheduler) permet ainsi de partager entre les équipements utilisateur les ressources du canal physique DL-SCH (accompagné du PDCCH, canal de signalisation associé).

Les réseaux LTE utilisent une technique d'accès multiple par répartition en fréquences orthogonales (en anglais OFDM, pour « Orthogonal Frequency Division Multiplexing"). Les ressources de transmission radio comprennent des blocs ou (P)RBs (pour « (Physical) Resource Blocks ») constitués chacun d'un ensemble de 12*14 éléments de ressource (en anglais « resource elements ») qui sont des symboles. Un élément de ressource est une ressource temps-fréquence de largeur 15 KHz et de durée Ts égale à un « temps-symbole ».

Les procédures de codage canal, d'adaptation de débit ainsi que les canaux de transport, dans les sens montant (de l'équipement utilisateur vers l'infrastructure de réseau) et descendant (de l'infrastructure de réseau vers l'équipement utilisateur), sont décrits dans la spécification technique 3G TS 36.212, « Multiplexing and channel coding », version 8.6.0, publiée par le 3GPP en mars 2009.

Le schéma de modulation/codage (ou MCS) est choisi par l'ordonnanceur MAC en fonction de la qualité en cours du lien radio. Les définitions des ressources de transmission radio allouées et du schéma de modulation/codage choisi sont transmises à l'entité émettrice ou réceptrice concernée via un canal de signalisation (appelé « PDCCH » pour le sens descendant (ou DL) et « PUCCH » pour le sens montant (ou UL)). Il leur correspond une taille de bloc de transport (ou TBS, référencée B dans la spécification 3GPP 36.212 précitée) que l'ordonnanceur MAC détermine dans une table prédéfinie qui est partagée entre les entités émettrice et réceptrice. Une fois que l'ordonnanceur MAC a déterminé la taille des blocs de transport, il demande à un élément RLC (appartenant à la couche de réseau du modèle OSI) de fournir des blocs de bits à transmettre ayant cette taille (à un entête près, étant donné que le TBS correspond à la somme du nombre de bits de données utiles (ou « payload ») et du nombre de bits d'entête MAC et/ou RLC).

En émission dans le sens descendant, la partie de la chaîne de transmission qui est dédiée au codage comprend un module d'encodage, puis un adaptateur de débit (ou « rate matching »). Plus précisément, les données à encoder (et donc devant être transportées dans un bloc de transport de taille TBS (ou B)) sont traitées par un dispositif de segmentation et d'ajout de CRC (correction d'erreurs), encodées (par un turbo code ou ou un code convolutif), puis traitées par le module d'adaptation de débit. Une suite de traitements équivalente est mise en oeuvre dans le sens montant.

On constate que le gain d'un turbo code (en terme de capacité à réduire les erreurs de transmission - estimée par exemple à partir du taux d'erreur blocs ou « BLER ») augmente avec la taille du bloc de transport entrant, jusqu'à atteindre un palier pour des blocs de transport de taille supérieure à un seuil égal à 6144 bits. Par conséquent, on est contraint de découper (ou segmenter) le bloc de transport entrant en segments lorsque sa taille est supérieure au seuil. Lors de cette segmentation il est préférable d'équilibrer les tailles des segments résultants. En reprenant les notations de la spécification 3GPP 36.212 précitée, on découpe donc chaque bloc de transport (de taille B) en C segments, en adjoignant à chaque segment un CRC de taille L.

On notera que l'on ne peut pas effectuer la segmentation en divisant simplement le bloc de transport en un nombre prédéterminé de segments, car les tailles permises de ces segments sont limitées en raison de contraintes liées à l'entrelacement des données dans le turbo codeur. Le nombre de tailles possibles pour les segments est donc limité, et les différentes tailles permises sont recensées dans une table de la spécification 3GPP 36.212 précitée (et plus précisément dans les colonnes des paramètres Ki mentionnées à la section 5.1.3-3 (p. 14)).

Il faudrait donc trouver à chaque fois des valeurs de Ki dont la somme est égale à la taille initiale du bloc de transport.

En général, lorsque l'on divise la taille du bloc de transport B, on obtient une valeur qui est bornée par une valeur inférieure et une valeur supérieure dans la table précitée. On a alors deux tailles possibles de segments : une taille K+ (arrondi dans la table par valeur supérieure) et une taille K- (arrondi dans la table par valeur inférieure) auxquelles correspondent respectivement un nombre C+ de blocs de taille K+ et un nombre C- de blocs de taille K-. Par exemple, si B = 9000 et C (nombre de segments) = 2, on obtient un ratio B/C = 4500 qui est borné par les valeurs K- = 4480 et K+ = 4544 dans la table précitée.

L'algorithme décrit à la section 5.1.2 de la spécification TS 36.212 précitée propose, afin de compenser la différence de taille avec le(s) autre(s) segment(s) de la segmentation, l'ajout de données (ou bits) de bourrage (ou « filler bits » - de valeur <NULL>) au début du premier segment de la segmentation. On observe que la mise en oeuvre de cet algorithme conduit à une perte de performances, en particulier pour des débits élevés.

L'invention a donc pour but d'améliorer la situation.

Elle propose à cet effet un procédé, dédié à la segmentation de blocs de transport de données en segments, et comprenant les étapes consistant : i) à segmenter un bloc de transport de données à transmettre, de taille donnée (B), en un nombre entier (C) de segments de tailles (K+') sensiblement identiques, tel que la somme des tailles de ces segments soit supérieure ou égale à la somme (B') de la taille donnée (B) et du produit du

nombre entier (C) par un nombre (NC) de bits de correction d'erreurs, puis ii) à répartir de façon sensiblement équitable des données (ou bits) de bourrage dans les segments.

En effet, l'algorithme de segmentation actuellement spécifié induit des variations du taux de codage des différents segments d'une segmentation. Tous les segments produits par l'algorithme de segmentation sont traités par le module d'adaptation de débit (rate matching), et plus précisément font l'objet de poinçonnages (ou « pruning » - suppression de bits) et/ou d'insertion de bits. Or, les bits de bourrage insérés dans le premier segment étant transparents pour le module de codage canal ainsi que pour l'adaptateur de débit, ils sont donc codés comme les autres bits par le dispositif de codage et d'insertion de CRC, puis éventuellement poinçonnés par l'adaptateur de débit, et ce même si, au final, on les extrait de la séquence de sortie de l'adaptateur de débit afin de ne pas être transmis. Par conséquent, il peut y avoir moins de données utiles poinçonnées dans le premier segment que dans les autres segments d'une même segmentation, et donc les données utiles du premier segment sont mieux protégées que celles des segments suivants.

Un tel déséquilibre de protection est inutile, étant donné que si l'un des segments d'un bloc de transport n'est pas correctement reçu (c'est-à-dire erroné au décodage), c'est l'ensemble du bloc de transport qui est perdu, et donc tous les segments qui le constituent devront être répétés, ce qui explique la perte de performances observées pour des débits élevés.

Le procédé proposé peut comporter d'autres caractéristiques qui peuvent être prises séparément ou en combinaison, et notamment :
- à l'étape i) :
   - on peut comparer la taille donnée (B) du bloc de transport de données à des valeurs de tailles qui sont stockées dans une table dans des paires de valeurs maximale et minimale, afin de déterminer la plus petite valeur maximale (K+) dont le résultat (C*K+) de la multiplication par le nombre entier (C) est supérieur ou égal à la somme (B'), puis
   - si le nombre entier (C) est supérieur à 1, on peut déterminer dans la table la paire qui comporte la plus grande valeur minimale (K-) strictement inférieure à la plus petite valeur maximale (K+) et l'on peut calculer l'écart (ΔK) entre la plus petite valeur maximale (K+) et cette plus grande valeur minimale (K-), la différence (SS) entre le produit (C×K+) du nombre entier (C) par la plus petite valeur maximale (K+) et la somme (B'), le rapport (R) entre la différence (SS) et cet écart (ΔK), et un autre nombre entier (C-) immédiatement inférieur ou égal au rapport (R), puis
   - si l'autre nombre entier (C-) est strictement supérieur à 0, on peut déterminer dans la table une nouvelle valeur maximale (K+') strictement supérieure à la plus petite valeur maximale (K+) et constituant la taille des segments dont le nombre est choisi égal au nombre entier (C) ;

   ➢ la nouvelle valeur maximale (K+') peut être obtenue en effectuant au moins une itération (et par exemple quatre) ;
   ➢ à l'étape ii) on peut intégrer dans chaque segment un nombre de données de bourrage sensiblement égal à l'entier qui est immédiatement inférieur ou égal au rapport entre, d'une part, la différence entre le produit (C×K+') et la somme (B'), et d'autre part, le nombre entier (C).

L'invention propose également un dispositif, dédié à la segmentation de blocs de transport de données en segments au sein d'une chaîne de transmission d'un réseau de communication de type LTE, et agencé :
- pour segmenter un bloc de transport de données à transmettre, de taille donnée (B), en un nombre entier (C) de segments de tailles (K+') sensiblement identiques, tel que la somme des tailles de ces segments soit supérieure ou égale à la somme (B') de la taille donnée (B) et du produit du nombre entier (C) par un nombre (NC) de bits de correction d'erreurs, et
- pour répartir de façon sensiblement équitable des données (ou bits) de bourrage dans les segments.

L'invention propose également un équipement de réseau destiné à faire partie d'une chaîne de transmission d'un réseau de radiocommunication, et équipé d'un dispositif de segmentation du type de celui présenté ci-avant.

D'autres caractéristiques et avantages de l'invention apparaîtront à l'examen de la description détaillée ci-après, et des dessins annexés, sur lesquels :
- la figure 1 illustre de façon très schématique et fonctionnelle un exemple de réseau LTE comprenant des stations de base équipées d'un dispositif de segmentation selon l'invention, et
- la figure 2 est un diagramme de l'évolution du débit d'une chaîne de transmission d'un réseau LTE (en kilobits par seconde (ou kbps)) en fonction du rapport porteuse / bruit (C/N) en dB, pour quatre configurations différentes.

Les dessins annexés pourront non seulement servir à compléter l'invention, mais aussi contribuer à sa définition, le cas échéant.

Dans la présente description, l'invention sera décrite plus particulièrement dans son application, non limitative, aux réseaux de radiocommunication de troisième génération de type LTE (« Long Term Evolution »).

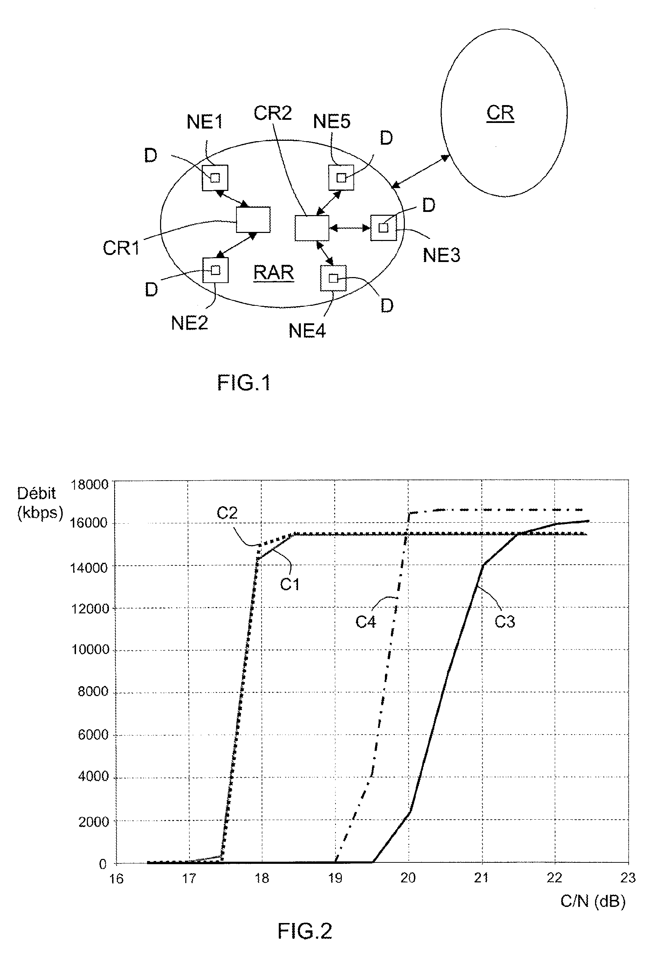

La figure 1 montre l'architecture d'un réseau de radiocommunication de type LTE. Ce réseau comprend un réseau coeur (en anglais, « core network ») appelé "Evolved Packet Core" (EPC), relié d'une part à un ou plusieurs réseaux de paquets de données (en anglais PDN, pour "packet data networks") comme par exemple des réseaux IP 17a, 17b, et d'autre part au réseau d'accès radio 1 appelé E-UTRAN (pour « Evolved Universal Terrestrial Radio Access Network »), au moyen d'une interface logique appelée S1. Les spécifications ne définissent qu'un seul noeud, appelé eNode-B (ou eNB) comme élément de réseau de l'E-UTRAN. Les eNBs 12a-12c sont distribuées sur le territoire de couverture de l'E-UTRAN 1, et sont chacun capables de communiquer sur l'interface air avec les terminaux mobiles 14a, 14b, 14c (aussi appelés UE pour "User Equipment"), sur des zones de couverture radio respectives aussi appelées cellules 13. Chaque eNB comporte une ou plusieurs stations de base desservant chacune une ou plusieurs cellules. L'interface logique entre les eNBs 12a - 12c et les UEs 14a, 14b, 14c est appelée interface *Uu.* Les eNBs 12a-12c sont interconnectés de manière à former un réseau de type maillé, et communiquent l'un avec l'autre au moyen d'une interface logique appelée *X2*.

Le procédé (de segmentation) comprend deux étapes principales, mises en oeuvre par exemple au sein d'un dispositif de segmentation D présent dans les eNBs 12a-12c.

Dans une première étape (i), on segmente un bloc de transport de données BT, reçu, devant être transmis et de taille donnée B, en un nombre entier C choisi de segments Si (i = 1 à C) de tailles K+' sensiblement identiques. Ce nombre entier C est choisi de sorte que la somme (C×K+') des tailles K+' des segments Si soit supérieure ou égale à la somme B' de la taille donnée B et du produit du nombre entier C par un nombre NC de bits de correction d'erreurs (ou bits de CRC), soit C×K+' ≥B', avec B' = B + C×NC.

Il est important de noter que les références B, B' et C désignent des paramètres qui sont équivalents à ceux qui sont utilisés dans la spécification TS 36.212 précitée.

Dans une deuxième étape (ii) on répartit de façon sensiblement équitable des données (ou bits) de bourrage (par exemple de valeur NULL) dans les C segments Si. On entend ici par « répartition sensiblement équitable » une répartition consistant à intégrer (ou insérer) sensiblement le même nombre de bits de bourrage dans chacun des C segments Si. On pourra rechercher par exemple, dans un mode particulier de réalisation, à répartir un même nombre de bits de bourrage dans chacun des C segments Si, avec une marge de plus ou moins un bit de bourrage en cas de problème d'arrondi.

On comprendra que grâce à cette répartition équitable, on peut obtenir un taux de poinçonnage sensiblement uniforme sur les C segments Si, sans se préoccuper du poinçonnage des bits de bourrage, puisque, comme indiqué ci-dessus, les bits de bourrage insérés dans les segments sont transparents pour le module de codage canal ainsi que pour l'adaptateur de débit (ils sont en effet extraits de la séquence de sortie de l'adaptateur de débit afin de ne pas être transmis). Ce moindre taux de poinçonnage permet d'obtenir le cas échéant un turbo encodage plus efficace.

La première étape (i) peut par exemple se dérouler comme indiqué ci-après :
On compare (par exemple au sein d'un dispositif D d'un eNB) la taille donnée B du bloc de transport de données BT qui doit être transmis à des valeurs de tailles qui sont stockées dans une table dans des paires de valeurs maximale et minimale (référencées respectivement K+ et K- dans les colonnes des paramètres Kᵢ de la section 5.1.3-3 de la spécification 3GPP 36.212-précitée). Cette table est par exemple stockée dans le dispositif D concerné.

Cette comparaison est destinée à déterminer la plus petite valeur maximale K+ de la table, référencée K, qui, lorsqu'elle est multipliée par le nombre entier C, permet d'obtenir un résultat (C×K) supérieur ou égal à la somme B', soit C×K ≥B' (avec B' = B + C×NC).

Si le nombre entier C trouvé est égal à un (C = 1), alors on (le dispositif D concerné) « segmente » le bloc de transport BT en un unique segment S1 (i = 1 car C = 1) de taille K (égale à la plus petite valeur maximale K+ trouvée dans la table et vérifiant C×K ≥B').

En revanche, si le nombre entier C trouvé est strictement supérieur à un (C > 1), alors on (le dispositif D concerné) détermine dans la table la paire qui comporte la plus grande valeur minimale K- (ici référencée K-) qui est strictement inférieure à la plus petite valeur maximale K+ (précédemment déterminée et référencée K, et que l'on référence maintenant K+), soit K- < K+ (avec K+ = K). Puis, on (le dispositif D concerné) calcule :
- l'écart ΔK entre la plus petite valeur maximale K+ (ici référencée K+) et la plus grande valeur minimale K- (ici référencée K-), soit ΔK = K+ - K-,
- la différence SS entre le produit C×K+ du nombre entier C par la plus petite valeur maximale K+ (ici référencée K+) et la somme B', soit SS = C×K+ - B',
- le rapport R entre la différence SS et l'écart ΔK, soit R = SS/ΔK, et
- un autre nombre entier, référencé C-, qui est la partie entière de R, c'est-à-dire l'entier immédiatement inférieur ou égal à la valeur du rapport R, soit C- = └*R*┘ (où l'opérateur └ ┘ est appelé « floor »).

Si cet autre nombre entier C- est égal à zéro (C- = 0), alors on (le dispositif D concerné) « segmente » le bloc de transport BT en un unique segment S1 de taille K+ (égale à la plus petite valeur maximale K+ trouvée dans la table et vérifiant C×K+ ≥B').

En revanche, si cet autre nombre entier C- est strictement supérieur à zéro (C- > 0), alors on (le dispositif D concerné) détermine dans la table une nouvelle valeur maximale K+, référencée K+', qui est strictement supérieure à la plus petite valeur maximale K+ (référencée K+ ci-avant), soit K+' > K+. Cette nouvelle valeur maximale K+, ici référencée K+', constitue alors la taille des segments Si à transmettre, et le nombre de ces derniers (Si) est choisi égal au nombre entier C précédemment trouvé. Il s'agit ici de faire croître la taille des segments Si à partir de la valeur K+ afin de pouvoir répartir de façon sensiblement homogène des bits de bourrage dans chacun de ces segments Si.

Pour ce faire, on peut par exemple procéder de façon itérative au moins une fois, et par exemple quatre fois (nₘₐₓ = 4, et n = 1 à nₘₐₓ et représente le nombre total d'itérations successives), comme indiqué ci-dessous à titre d'exemple non limitatif.

On désigne par QPP la colonne des paramètres K de la table de la section 5.1.3-3 de la spécification TS 36.212 précitée), et par 1 l'indice de K+' dans cette table (avec I = 1 à 188), soit QPP[I] = K+'. Lors de chaque itération, on identifie I à la plus petite valeur entre 188 et (I + n), où n est la valeur en cours pour l'itération considérée, soit I = min(I+n, 188), et on identifie K+' à QPP[I + n], soit K+' = QPP[I + n]. La valeur prise par K+' à la fin de la dernière itération est celle qui est retenue pour chaque segment Si.

On notera que le nombre total de bits de bourrage F devant être répartis peut ne pas être un multiple entier du nombre C de segments Si. Ce nombre F est égal à la différence entre le produit C×K+' et la somme B', soit F = C×K+' - B'. Le nombre moyen Fs de bits de bourrage par segment Si étant égal au rapport F/C, on comprendra que le nombre effectif de bits de bourrage par segment Si peut varier de plus ou moins une unité. Par exemple, si C est égal à 5 et que le nombre total de bits de bourrage à insérer est F, avec F = C×Fs +2 (où Fs est la partie entière du rapport entre F et C, c'est-à-dire l'entier immédiatement inférieur ou égal au résultat du rapport entre F et C (Fs = └*F*/*C*┘)), on peut insérer Fs bits de bourrage dans les trois premiers segments S1 à S3 et Fs + 1 bits de bourrage dans les deux derniers segments S4 et S5. D'une manière générale, on peut commencer par intégrer dans chaque segment Si le même nombre moyen de bits de bourrage Fs, puis on considère le nombre de bits de bourrage restant R (c'est-à-dire pas encore intégrés (ou distribués). Si R est égal à zéro (R = 0), cela signifie qu'il n'y a plus d'autres bits de bourrage à distribuer et donc que tous les segments Si ont exactement le même nombre de bits de bourrage. Le procédé prend alors fin. En revanche, si R est strictement supérieur à zéro (R > 0), alors on peut par exemple distribuer un bit de bourrage supplémentaire dans les R premiers segments S1 à SR ou dans les R derniers segments.

On a représenté sur la figure 2 un diagramme représentant l'évolution du débit d'une chaîne de transmission d'un réseau LTE (en kilobits par seconde (ou kbps)) en fonction du rapport porteuse / bruit (C/N) en dB pour quatre configurations différentes. Plus précisément :
- la courbe C1 matérialise le débit en fonction de C/N d'une chaîne de transmission d'un réseau LTE de l'art antérieur (c'est-à-dire ne mettant pas en oeuvre l'invention) en présence d'une modulation de type 64QAM et d'un schéma de modulation/codage de type MCS 14,
- la courbe C2 matérialise le débit en fonction de C/N d'une chaîne de transmission d'un réseau LTE mettant en oeuvre l'invention en présence d'une modulation de type 64QAM et d'un schéma de modulation/codage de type MCS 14,
- la courbe C3 matérialise le débit en fonction de C/N d'une chaîne de transmission d'un réseau LTE de l'art antérieur (c'est-à-dire ne mettant pas en oeuvre l'invention) en présence d'une modulation de type 64QAM et d'un schéma de modulation/codage de type MCS 15, et
- la courbe C4 matérialise le débit en fonction de C/N d'une chaîne de transmission d'un réseau LTE mettant en oeuvre l'invention en présence d'une modulation de type 64QAM et d'un schéma de modulation/codage de type MCS 15.

On peut constater sur ce diagramme l'effet particulièrement positif de la segmentation selon l'invention sur le débit en présence d'un schéma de modulation/codage de type MCS15, puisqu'il existe alors un gain d'au moins 1 dB, notamment dans la bande passante des 5 MHz. Par ailleurs, les performances en présence d'un schéma de modulation/codage de type MCS15 sont sensiblement indépendantes de la bande passante, ce qui permet de faciliter la mise en oeuvre de l'adaptation de lien (ou « link adaptation »).

On notera que chaque dispositif de segmentation D peut être réalisé sous la forme de circuits électroniques, de modules logiciels (ou informatiques), ou d'une combinaison de circuits électroniques et de modules logiciels.

L'invention ne se limite pas aux modes de réalisation de dispositif de segmentation, d'équipement de réseau et de procédé de segmentation décrits ci-avant, seulement à titre d'exemple, mais elle englobe toutes les variantes que pourra envisager l'homme de l'art dans le cadre des revendications ci-après.

## Revendications

1. Procédé de segmentation de blocs de transport de données en segments dans un réseau de radiocommunication, le procédé comprenant les étapes suivantes : i) segmenter un bloc de transport de données (BT) à transmettre, de taille donnée (B), en un nombre entier (C) de segments (Si) de tailles (K+') sensiblement identiques, tel que la somme des tailles desdits segments (Si) soit supérieure ou égale à la somme (B') de ladite taille donnée (B) et du produit dudit nombre entier (C) par un nombre (NC) de bits de correction d'erreurs, ii) répartir de façon sensiblement équitable des données de bourrage dans lesdits segments (Si).

2. Procédé selon la revendication 1, dans lequel, à l'étape i) :
- on compare ladite taille donnée (B) du bloc de transport de données (BT) à des valeurs de tailles stockées dans une table dans des paires de valeurs maximale et minimale, de manière à déterminer la plus petite valeur maximale (K+) dont le résultat (C×K+) de la multiplication par ledit nombre entier (C) est supérieur ou égal à ladite somme (B'), puis
- si ledit nombre entier (C) est supérieur à 1, on détermine dans ladite table la paire comportant la plus grande valeur minimale (K-) strictement inférieure à ladite plus petite valeur maximale (K+) et l'on calcule l'écart (ΔK) entre ladite plus petite valeur maximale (K+) et ladite plus grande valeur minimale (K-), la différence (SS) entre le produit (C×K+) dudit nombre entier (C) par ladite plus petite valeur maximale (K+) et ladite somme (B'), le rapport (R) entre la différence (SS) et ledit écart (ΔK), et un autre nombre entier (C-) immédiatement inférieur ou égal audit rapport (R), puis
- si ledit autre nombre entier (C-) est strictement supérieur à 0, on détermine dans ladite table une nouvelle valeur maximale (K+') strictement supérieure à ladite plus petite valeur maximale (K+) et constituant ladite taille des segments (Si) dont le nombre est choisi égal audit nombre entier (C).

3. Procédé selon la revendication 2, dans lequel ladite nouvelle valeur maximale (K+') est obtenue en effectuant au moins une itération.

4. Procédé selon la revendication 3, dans lequel ladite nouvelle valeur maximale (K+') est obtenue en effectuant quatre itérations.

5. Procédé selon l'une des revendications 2 à 4, dans lequel, à l'étape ii), on intègre dans chaque segment (Si) un nombre de données de bourrage sensiblement égal à l'entier qui est immédiatement inférieur ou égal au rapport entre, d'une part, la différence entre ledit produit (C×K+') et ladite somme (B'), et d'autre part, ledit nombre entier (C).

6. Dispositif (D) de segmentation de blocs de transport de données en segments pour une chaîne de transmission d'un réseau de radiocommunication, agencé i) pour segmenter un bloc de transport de données (BT) à transmettre, de taille donnée (B), en un nombre entier (C) de segments de tailles (K+') sensiblement identiques, tel que la somme des tailles de ces segments soit supérieure ou égale à la somme (B') de la taille donnée (B) et du produit du nombre entier (C) par un nombre (NC) de bits de correction d'erreurs, et ii) pour répartir de façon sensiblement équitable des données de bourrage dans lesdits segments (Si).

7. Dispositif selon la revendication 6 agencé:
- pour comparer ladite taille donnée (B) du bloc de transport de données (BT) à des valeurs de tailles stockées dans une table dans des paires de valeurs maximale et minimale, de manière à déterminer la plus petite valeur maximale (K+) dont le résultat (C×K+) de la multiplication par ledit nombre entier (C) est supérieur ou égal à ladite somme (B'), puis
- si ledit nombre entier (C) est supérieur à 1, pour déterminer dans ladite table la paire comportant la plus grande valeur minimale (K-) strictement inférieure à ladite plus petite valeur maximale (K+) et pour calculer l'écart (ΔK) entre ladite plus petite valeur maximale (K+) et ladite plus grande valeur minimale (K-), la différence (SS) entre le produit (C×K+) dudit nombre entier (C) par ladite plus petite valeur maximale (K+) et ladite somme (B'), le rapport (R) entre la différence (SS) et ledit écart (ΔK), et un autre nombre entier (C-) immédiatement inférieur ou égal audit rapport (R), puis
- si ledit autre nombre entier (C-) est strictement supérieur à 0, pour déterminer dans ladite table une nouvelle valeur maximale (K+') strictement supérieure à ladite plus petite valeur maximale (K+) et constituant ladite taille des segments (Si) dont le nombre est choisi égal audit nombre entier (C).

8. Dispositif selon la revendication 7 agencé pour effectuer au moins une itération pour obtenir ladite nouvelle valeur maximale (K+'),

9. Dispositif selon la revendication 8 agencé pour effectuer quatre itérations pour obtenir ladite nouvelle valeur maximale (K+').

10. Dispositif selon l'une des revendications 7 à 9, agencé pour intégrer dans chaque segment (Si) un nombre de données de bourrage sensiblement égal à l'entier qui est immédiatement inférieur ou égal au rapport entre, d'une part, la différence entre ledit produit (C*K+') et ladite somme (B'), et d'autre part, ledit nombre entier (C).

11. Equipement de réseau pour un réseau de radiocommunication, comprenant un dispositif de segmentation (D) selon l'une des revendications 6 à 10.
